# EUROPEAN PATENT APPLICATION

(11) **EP 1 981 068 A1**
(43) Date of publication of application: **15.10.2008**
(21) Application number: 06843042.0
(22) Date of filing: 22.12.2006
(51) Int. Cl.: H01L 21/205, H01L 21/3065

(54) **PLASMA PROCESSING APPARATUS AND SEMICONDUCTOR ELEMENT MANUFACTURED BY SUCH APPARATUS**

(30) Priority: 23.01.2006 JP 2006013947
(71) Applicant: Sharp Kabushiki Kaisha, Osaka-shi, Osaka 545-8522 (JP)
(72) Inventor: KISHIMOTO, Katsushi, Kyoto 619-0232 (JP); FUKUOKA, Yusuke, Nara 636-0111 (JP)
(74) Representative: Müller - Hoffmann & Partner
(86) International application number: PCT/JP2006/325583
(87) International publication number: WO 2007/083480

(57) **Abstract**

When a flow rate of a diluent gas is larger than a flow rate of a reaction gas, a reaction gas introducing tube (113) is connected to a part of a diluent gas introducing tube (111) which connects a plasma processing reaction chamber (101) to a diluent gas feeding unit (112). Thus, the reaction gas can be fully mixed with the diluent gas in the diluent gas introducing tube (111), and a gas feed piping can be of a simpler configuration.

## Description

### TECHNICAL FIELD

The present invention relates to a plasma processing apparatus, and more particularly, relates to a plasma processing apparatus characterized by a gas piping structure feeding gas to a plasma processing reaction chamber, and to a semiconductor device manufactured with the plasma processing apparatus.

### BACKGROUND ART

A plasma processing apparatus is an apparatus for generating a plasma between electrodes and plasma-processing a non-processed object which is rested on a cathode electrode or an anode electrode, by introducing a plurality of types of gases into a plasma processing reaction chamber including the cathode / anode electrode pair, regulating a pressure of a mixed gas in the reaction chamber to be generally constant by a pressure adjustment valve provided in an exhaust system, and applying a high voltage between the electrodes.

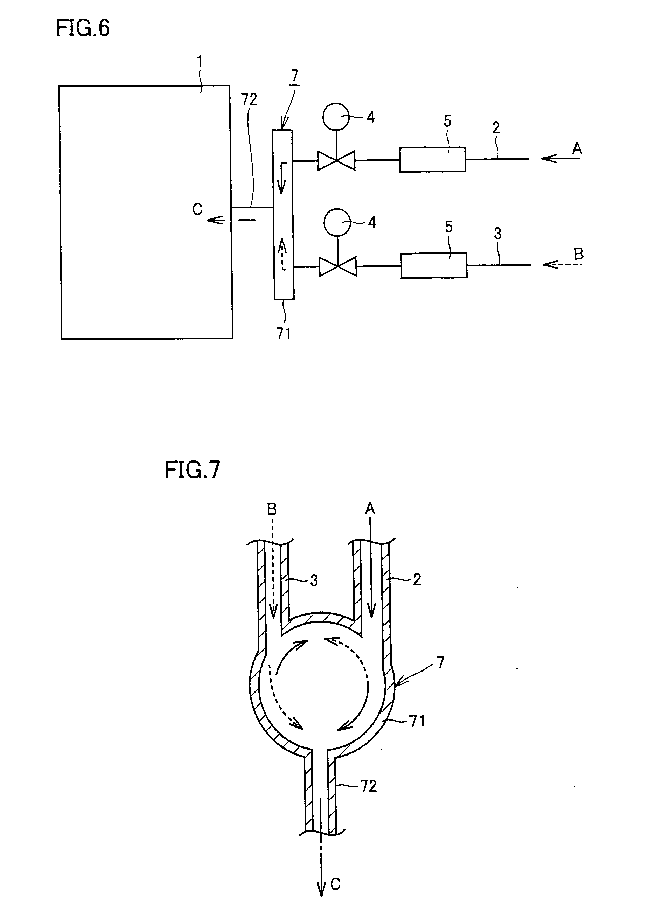

A conventional plasma processing apparatus is described based on the drawings. Fig. 6 is a diagram of a gas piping system of a conventional plasma processing apparatus. The structure is such that a mixing box 7 for mixing a plurality of gases A and B before introducing the gases into a reaction chamber 1 is provided, and gases A and B are mixed in mixing box 7 and then introduced into reaction chamber 1. Fig. 7 is a cross sectional view of the mixing box disclosed in Patent Document 1. It is shown that the shape of mixing box 7 is cylindrical and pressure loss can be reduced. Patent Document 1: Japanese Utility Model Laying-Open No. 64-26373

### DISCLOSURE OF THE INVENTION

### PROBLEMS TO BE SOLVED BY THE INVENTION

When the above-mentioned mixing box is used, however, it is necessary to provide the mixing box for every reaction chamber, leading to a problem of a complicated configuration of the gas piping system.

The present invention was made in view of the above-mentioned issue, and an object of the present invention is to implement mixing of a plurality of gases by a simple gas introducing piping, in a plasma processing apparatus for performing plasma processing by introducing a plurality of types of gases.

### MEANS FOR SOLVING THE PROBLEMS

In order to achieve the above-mentioned object, the present invention provides a plasma processing apparatus including a plasma processing reaction chamber, a diluent gas introducing tube introducing a diluent gas, having one end connected to the plasma processing reaction chamber, a diluent gas feeding unit connected to the other end of the diluent gas introducing tube, for feeding a diluent gas, a reaction gas introducing tube introducing a reaction gas, having one end connected to the dilution gas introducing tube at a location closer to the diluent gas feeding unit with respect to the midpoint of the diluent gas introducing tube, and a reaction gas feeding unit connected to the other end of the reaction gas introducing tube, for feeding the reaction gas at a flow rate smaller than a flow rate of the diluent gas.

According to the present configuration, when a plurality of types of gases are introduced into the plasma processing reaction chamber, the plurality of types of gases can be fully mixed and the gas introducing piping can be of a simpler configuration.

Moreover, in the present invention, the reaction gas introducing tube is desirably connected in the proximity of the diluent gas feeding unit.

In addition, in the present invention, the reaction gas includes a plurality of types of gases, each of which is a material gas or a doping gas, and a material gas introducing tube is desirably connected to the diluent gas introducing tube at a location closer to the plasma processing reaction chamber than a location where a doping gas introducing tube is connected.

Furthermore, in the present invention, an inner diameter of the diluent gas introducing tube is desirably larger than an inner diameter of the reaction gas introducing tube.

In the present invention, there are provided a plurality of sets of the plasma processing reaction chamber, the diluent gas introducing tube, the diluent gas feeding unit, the reaction gas introducing tube, and the reaction gas feeding unit, and it is desirable that the diluent gas feeding units are included in one vessel and the reaction gas feeding units are included in one vessel.

In addition, a semiconductor device manufactured with the plasma processing apparatus of the present invention is provided.

### EFFECTS OF THE INVENTION

In the present invention, when the flow rate of the diluent gas is larger than the flow rate of the reaction gas, the reaction gas introducing tube is connected to the diluent gas introducing tube, which connects the diluent gas feeding unit and the plasma processing reaction chamber, at a location closer to the diluent gas feeding unit, so that the diluent gas and the reaction gas can be fully mixed in the diluent gas introducing tube and the gas feed piping can be of a simpler configuration.

### BRIEF DESCRIPTION OF THE DRAWINGS

Fig. 1 shows a schematic cross sectional view and a diagram of a gas piping system of a plasma processing apparatus according to Embodiment 1 of the present invention.
Fig. 2 shows a schematic cross sectional view and a diagram of a gas piping system of a plasma processing apparatus according to Embodiment 2 and Example 2 of the present invention.
Fig. 3 is a diagram of a gas piping system of a plasma processing apparatus according to Embodiment 3 of the present invention.
Fig. 4 shows a schematic cross sectional view and a diagram of a gas piping system of a plasma CVD apparatus according to Example 2 of the present invention.
Fig. 5 is a diagram of a gas piping system of a plasma CVD apparatus according to Example 3 of the present invention.
Fig. 6 is a diagram of a gas piping system of a conventional plasma processing apparatus.
Fig. 7 is a schematic cross sectional view of a matching box according to a prior invention.

### DESCRIPTION OF THE REFERENCE SIGNS

101 plasma processing reaction chamber, 108 diluent gas, 112 diluent gas feeding unit, 111 diluent gas introducing tube, 109 reaction gas, 114 reaction gas feeding unit, 113 reaction gas introducing tube, 204 material gas feeding unit, 203 material gas introducing tube, 202 doping gas feeding unit, 210 doping gas introducing tube.

### BEST MODES FOR CARRYING OUT THE INVENTION

### (Embodiment 1)

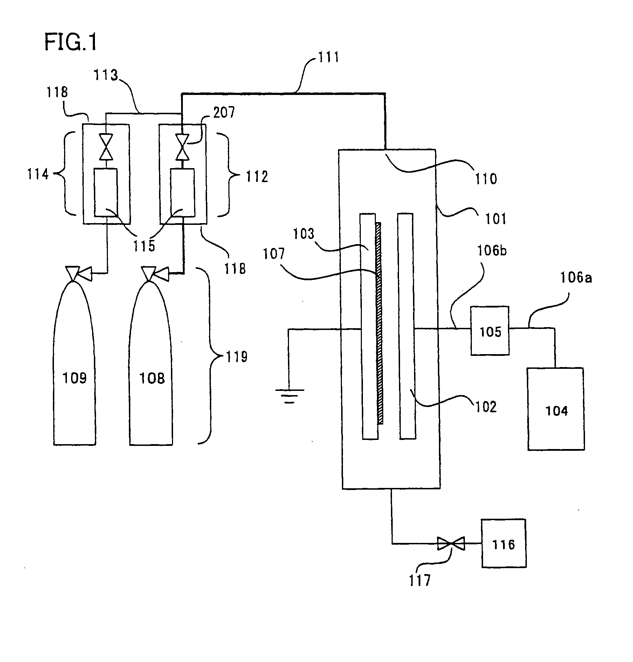

A plasma processing apparatus according to Embodiment 1 of the present invention is described based on a drawing. Fig. 1 shows a schematic cross sectional view and a diagram of a gas piping system of a plasma processing apparatus according to Embodiment 1 of the present invention. A cathode electrode 102 / anode electrode 103 pair is arranged inside a sealable plasma processing reaction chamber 101, and a power supply 104 supplying electric power to cathode electrode 102 and a matching box 105 performing impedance matching between power supply 104 and a plurality of cathode electrode 102 / anode electrode 103 pairs are arranged outside plasma processing reaction chamber 101.

One end of a power lead wire 106a is connected to power supply 104, and the other end is connected to matching box 105. One end of a power lead wire 106b is connected to matching box 105 and the other end is connected to cathode electrode 102.

On the other hand, anode electrode 103 is electrically grounded, and a workpiece 107, which is an object for plasma processing, is arranged on anode electrode 103. Workpiece 107 may also be arranged on cathode electrode 102, and when surfaces of anode electrode 103 and cathode electrode 102 are plasma processed, workpiece 107 does not need to be arranged.

A gas inlet 110 is provided in plasma processing reaction chamber 101. One end of a diluent gas introducing tube 111 is connected to gas inlet 110, and the other end is connected to diluent gas feeding unit 112. A flow control device 115, such as a mass flow controller and the like, is provided in diluent gas feeding unit 112, in order to feed diluent gas 108 at a predetermined flow rate. A valve 207 may also be provided at an appropriate location. An inert gas such as N₂, Ar, He, Ne and the like, or H₂ and the like is used as diluent gas 108.

When a combustible gas, a combustion-assisting gas or a toxic gas is used, a configuration is normally employed in which flow control device 115 and valve 207 are included in a gas box 118, and the gas inside gas box 118 is exhausted and emitted to the atmosphere through a harm eliminating device (not shown) to deal with a gas leak. Moreover, a gas detector (not shown) for detecting a gas leak is also provided in the chamber or in an exhaust piping.

Moreover, even in a case where an inert gas is used, a configuration is employed in which flow control device 115 and valve 207 are included in gas box 118, and the gas inside gas box 118 is exhausted and emitted to the atmosphere, in order to prevent the inert gas from prevailing in case of a gas leak.

In the present embodiment and in subsequent embodiments and examples, a gas feeding unit includes at least flow control device 115 having a function to control the gas flow rate, and whether or not the unit includes a gas reservoir 119, such as a gas canister and the like, is not considered. For example, as in the present embodiment, a configuration may be such that gas reservoir 119 is separately provided and gas is fed to a gas feeding unit through a gas piping, or gas reservoir 119 can also be provided within a gas feeding unit.

One end of a reaction gas introducing tube 113 is connected to diluent gas introducing tube 111, and the other end is connected to a reaction gas feeding unit 114. Reaction gas feeding unit 114 feeds a reaction gas at a flow rate smaller than a flow rate of diluent gas 108. Flow control device 115, such as a mass flow controller and the like, is provided in reaction gas feeding unit 114. A material gas such as SiH₄, CH₄, GeH₄ and the like, or an etching gas such as NF₃, SF₆, CF₄ and the like is used as reaction gas 109.

The configuration is such that reaction gas feeding unit 114 is included in gas box 118, and the gas inside gas box 118 is exhausted and emitted to the atmosphere through a harm eliminating device. Moreover, a gas detector detecting a leaked gas is also provided in gas box 118.

Reaction gas introducing tube 113 is desirably connected to diluent gas introducing tube 111 at a location closer to diluent gas feeding unit 112 with respect to the midpoint of diluent gas introducing tube 111, and more desirably connected in the proximity of diluent gas feeding unit 112. By connecting reaction gas introducing tube 113 to diluent gas introducing tube 111 at a location closer to diluent gas feeding unit 112, a distance from the connecting location to plasma processing reaction chamber 101 is made long enough for efficient mixing of the gases, and reaction gas introducing tube 113 is made short enough to achieve a simplified gas piping.

Furthermore, the inner diameter of diluent gas introducing tube 111 is desirably larger than the inner diameter of reaction gas introducing tube 113. The effect resides in that the larger the internal volume of diluent gas introducing tube 111 is, the more efficiently the gases are mixed.

A vacuum pump 116 and a pressure adjustment valve 117 are connected to plasma processing reaction chamber 101 and the gas pressure is kept generally constant in plasma processing reaction 101, and by supplying electric power from power supply 104 to cathode electrode 102a, a plasma discharge is generated between the cathode electrode 102 / anode electrode 103 pair to thereby perform the plasma processing.

### (Embodiment 2)

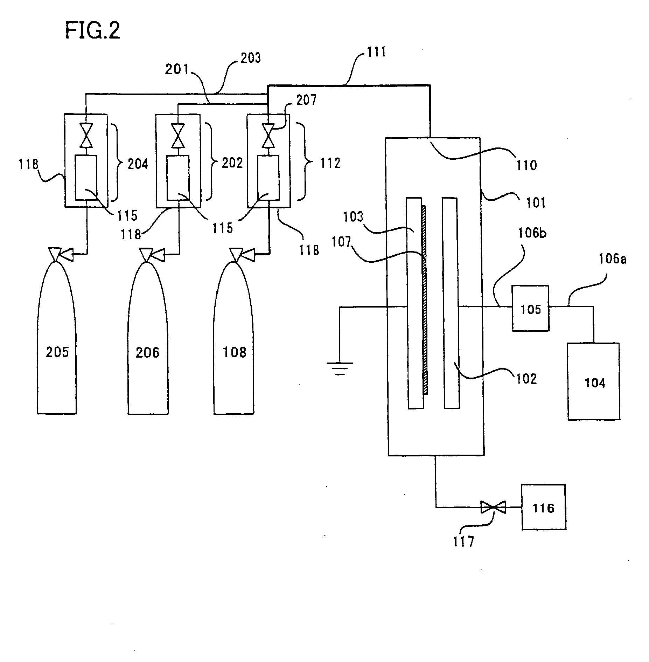

A plasma processing apparatus according to Embodiment 2 of the present invention is described based on a drawing. Fig. 2 shows a schematic cross sectional view and a diagram of a gas piping system of a plasma processing apparatus according to Embodiment 2 of the present invention. The configuration other than the gas feeding unit and the gas piping portion is substantially the same as that of Embodiment 1.

One end of a doping gas introducing tube 201 is connected to diluent gas introducing tube 111, and the other end is connected to a doping gas feeding unit 202. One end of a material gas introducing tube 203 is connected to diluent gas introducing tube 111 at a point closer to plasma processing reaction chamber 101 than the point where doping gas introducing tube 201 is connected, and the other end of material gas introducing tube 203 is connected to a material gas feeding unit 204.

Although a single system is provided for each of a material gas 205 and a doping gas 206 in the present embodiment, there may be provided a plurality of systems. In that case, it is desirable that a system smaller in a required flow rate, out of the systems for material gas 205 and doping gas 206, is connected to diluent gas introducing tube 111 at a location closer to reaction gas feeding unit 114.

It is also possible to provide valve 207 at a required location, for selecting a gas for use. An inert gas such as N₂, Ar, He, Ne and the like, or H₂ and the like is used as diluent gas 108, SiH₄, CH₄, or GeH₄ or the like is used as material gas 205, and PH₃, AsH₃, B₂H₆ or the like is used as doping gas 206.

The present embodiment is also configured such that gas box 118 includes a gas feeding unit, as in Embodiment 1.

In a case where a semiconductor film is deposited with a plasma CVD method, the concentration of doping gas 206 is as low as the ppm order of an amount of material gas 205, and the doping gas needs to be reliably mixed with the material gas and the diluent gas. In order to efficiently mix material gas 205, doping gas 206 and diluent gas 108, it is desirable to introduce material gas 205 and doping gas 206 into diluent gas introducing tube 111 at a location farther from plasma processing reaction chamber 101.

Moreover, the inner diameter of diluent gas introducing tube 111 is desirably larger than inner diameters of material gas introducing tube 203 and doping gas introducing tube 201. The larger the internal volume of diluent gas introducing tube 111 is, the more efficiently gases are mixed.

### (Embodiment 3)

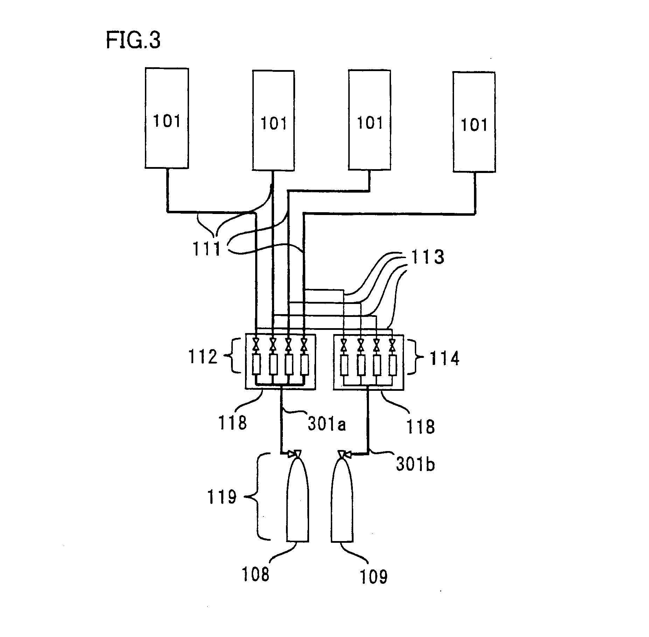

A plasma processing apparatus according to Embodiment 3 of the present invention is described based on a drawing. Fig. 3 is a diagram of a gas piping system of the plasma processing apparatus according to Embodiment 3 of the present invention. The configuration is such that a plurality of plasma processing reaction chambers 101 are provided, and diluent gas introducing tubes 111 from diluent gas feeding units 112 are connected to plasma processing reaction chambers 101, respectively. Reaction gas introducing tube 113 is connected to diluent gas introducing tube 111 as in Embodiment 1.

In a case where a plurality of plasma processing reaction chambers 101 are provided, if gas feeding units are provided at separate locations corresponding to respective plasma processing reaction chambers 101, a plurality of gas boxes 118 are needed for respective gas feeding units of the same type, and each gas box 118 needs a gas detector.

In the present embodiment, gas feeding units for diluent gas 108 are put together in single gas box 118, and gas feeding units for reaction gas 109 are put together in another single gas box 118. The present configuration is efficient because required gas boxes 118 can be reduced in number and the required gas detectors can be reduced in number.

Moreover, a case where a plurality of plasma processing reaction chambers 101 are provided is advantageous in that gases are mixed more efficiently while passing through diluent gas introducing tube 111 because the length of each diluent gas introducing tube 111 is inevitably long and its internal volume increases. Furthermore, the configuration has an effect of reducing the piping volume, because gas feed pipings 301a and 301 b from gas reservoirs 119 to gas feeding units 112 and 114, respectively, should only be provided for respective types of gases.

It is also possible to configure the gas piping for individual plasma processing reaction chamber 101 in the same way as in Embodiment 2.

### (Example 1)

A plasma processing apparatus according to Example 1 is described based on a drawing, referring to a plasma etching apparatus as an example.

A schematic cross sectional view of the plasma etching apparatus according to the present example is similar to Fig. 1, and therefore the description will be given hereinafter based on Fig. 1. Anode electrode 103 and cathode electrode 102 are arranged inside plasma processing reaction chamber 101 such that they are opposed to each other, an etching gas and diluent gas 108 is introduced into plasma processing reaction chamber 101, and by supplying electric power to cathode electrode 102, a plasma discharge is generated between anode electrode 103 and cathode electrode 102.

This plasma etching apparatus will be described more specifically. The cathode electrode 102 / anode electrode 103 pair is arranged in the center in the inside of sealable, vertical plasma processing reaction chamber 101, approximately perpendicularly to a bottom surface of plasma processing reaction chamber 101. A glass substrate on which a silicon thin film is deposited is arranged as a workpiece 107 on a surface of anode electrode 103.

Stainless steel, aluminum alloy or the like is used for plasma processing reaction chamber 101, and ceramics or the like is used as a heat insulating material. Anode electrode 103 is manufactured from a conductive and heat resistant material such as stainless steel, aluminum alloy, carbon, and the like.

Workpiece 107 could be any non-etched object and is not particularly limited. In a case where the reaction chamber is also used as a plasma CVD apparatus, workpiece 107 does not need to be arranged when the inside of the reaction chamber is cleaned.

The dimension of anode electrode 103 is determined to an appropriate value in accordance with the dimension of workpiece 107 to be etched. In the present example, the dimension of anode electrode 103 is set to 1000 mm × 1000 mm, corresponding to the dimension of the glass substrate of 900 mm × 900 mm.

Though cathode electrode 102 is produced from aluminum alloy, it may be produced from stainless steel and the like. The dimension of cathode electrode 102 is set to an appropriate value in accordance with the dimension of workpiece 107. It is set to 1000 mm ×1000 mm in the present example.

Anode electrode 103, cathode electrode 102 and the glass substrate may not be restricted to these sizes but may be of any size. Normally, however, the size of 500 - 1500 mm is used.

Gas inlet 110 is provided in plasma processing reaction chamber 101. One end of diluent gas introducing tube 111 is connected to gas inlet 110, and the other end is connected to diluent gas feeding unit 112. A mass flow controller is provided as flow control device 115 in diluent gas feeding unit 112 in order to feed diluent gas 108 at a predetermined flow rate, thereby allowing flow rate control.

Ar gas is used as diluent gas 108. In the configuration, diluent gas feeding unit 112 is included in gas box 118 and the gas inside gas box 118 is exhausted and emitted to the atmosphere.

One end of reaction gas introducing tube 113 is connected to a part of diluent gas introducing tube 111, and the other end is connected to reaction gas feeding unit 114. A mass flow controller is provided also in reaction gas feeding unit 114 as in diluent gas feeding unit 112, thereby allowing flow rate control.

NF₃ gas is used as reaction gas 109. The configuration is such that reaction gas feeding unit 114 is included in gas box 118 and gas box 118 is connected to an exhaust system for emitting the gas through a harm eliminating device to the atmosphere.

The material of each gas introducing tube is determined depending on a type of gas to be used and its pressure. Any material with corrosion resistance and pressure resistance may be used, and commonly used stainless steel is used in the present example.

The inner diameter of diluent gas introducing tube 111 is preferably larger than the inner diameter of reaction gas introducing tube 113 in order to perform gas mixing efficiently. The size of inner and outer diameters of each gas introducing tube is determined depending on the flow rate and pressure of the gas used, and any size is possible. In the present example, a gas introducing tube of 3/8 inch size is used as diluent gas introducing tube 111 and a gas introducing tube of 1/4 inch size is used as reaction gas introducing tube 113.

The configuration is such that pressure adjustment valve 117 and vacuum pump 116 are provided in series for plasma processing reaction chamber 101, so that the gas pressure in plasma processing reaction chamber 101 can be kept generally constant. In the present example, Ar gas serving as diluent gas 108 is fed at 5 SLM and NF₃ gas serving as reaction gas 109 is fed at 1 SLM, and the gas pressure in plasma processing reaction chamber 101 is set to 300 Pa. The condition is by way of example and other gas flow rates and gas pressures are possible, however, normally Ar gas is set to 1 - 5 SLM, NF3 gas is set to 0.1 - 1 SLM and a gas pressure is set to 100 - 500 Pa.

The configuration is such that electric power is supplied to cathode electrode 102 from plasma excitation power supply 104. As power supply 104, an alternating-current power supply with the frequency of 13.56 MHz and the output power of 1 kW is used. Although an alternating-current power supply with the frequency of about 1.00 MHz - 100 MHz and the output power of about 10 W - 100 kW is commonly used as power supply 104, it is not restricted as such but a direct-current power supply can also be used.

Between power supply 104 and plasma processing reaction chamber 101, matching box 105 matching the impedance between cathode electrode 102 / anode electrode 103 and power supply 104 is disposed. Power supply 104 and matching box 105 are connected by power lead wire 106a, and matching box 105 and cathode electrode 102 are connected by power lead wire 106b. Anode electrode 103 is structured to be electrically grounded.

In the plasma processing apparatus configured as above, the silicon thin film on the surface of workpiece 107 is etched by applying a high frequency power to cathode electrode 102 and generating a glow discharge region (plasma discharge region) between cathode electrode 102 and anode electrode 103.

This plasma etching apparatus can be used for etching of a silicon thin film, for example.

### (Example 2)

A plasma processing apparatus according to Example 2 is described based on a drawing, referring to a plasma CVD apparatus as an example.

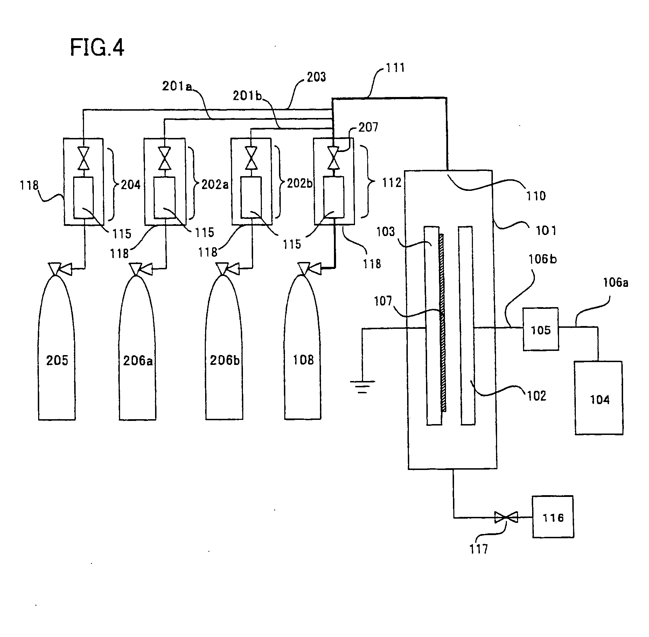

Fig. 4 shows a schematic cross sectional view and a diagram of a gas piping system of a plasma CVD apparatus according to the present example. Anode electrode 103 and cathode electrode 102 are arranged in plasma processing reaction chamber 101 such that they are opposed to each other, reaction gases 205, 206a, and 206b and diluent gas 108 are introduced into plasma processing reaction chamber 101, and by supplying electric power to cathode electrode 102, a plasma discharge is generated between anode electrode 103 and cathode electrode 102.

The plasma etching apparatus will be described more specifically. The cathode electrode 102 / anode electrode 103 pair is arranged in the center in the inside of sealable, vertical plasma processing reaction chamber 101, approximately perpendicularly to a bottom surface of plasma processing reaction chamber 101. A glass substrate for depositing a silicon semiconductor thin film is arranged on the surface of anode electrode 103 as workpiece 107, which is an object to be processed.

Stainless steel, aluminum alloy or the like is used for plasma processing reaction chamber 101, and ceramics or the like is used as a heat insulating material. Anode electrode 103 is manufactured from a conductive and heat resistant material such as stainless steel, aluminum alloy, carbon, and the like.

Workpiece 107 can be of any material for depositing a semiconductor thin film, and glass, metal, a semiconductor wafer, a film substrate or the like is commonly used.

The dimension of anode electrode 103 is determined to an appropriate value in accordance with the dimension of workpiece 107 for film depositing. In the present example, the dimension of anode electrode 103 is set to 1000 mm × 1000 mm, corresponding to the dimension of the glass substrate of 900 mm × 900 mm.

Though cathode electrode 102 is produced from aluminum alloy, it may be produced from stainless steel and the like. The dimension of cathode electrode 102 is set to an appropriate value in accordance with the dimension of workpiece 107, and it is set to 1000 mm ×1000 mm in the present example.

Anode electrode 103, cathode electrode 102 and the glass substrate may not be restricted to these sizes and may be of any size. Normally, however, the size of 500 - 1500 mm is used.

Gas inlet 110 is provided in plasma processing reaction chamber 101. One end of diluent gas introducing tube 111 is connected to gas inlet 110, and the other end is connected to diluent gas feeding unit 112. A mass flow controller is provided as flow control device 115 in diluent gas feeding unit 112, in order to feed diluent gas 108a at a predetermined flow rate, thereby allowing flow rate control.

H₂ gas is used as diluent gas 108. In the configuration, diluent gas feeding unit 112 is included in gas box 118 and gas box 118 is connected to an exhaust system for emitting the gas through a harm eliminating device to the atmosphere.

One ends of doping gas introducing tubes 201 a and 201 b are connected to a part of diluent gas introducing tube 111, and the other ends are connected to doping gas feeding units 202a and 202b. One end of material gas introducing tube 203 is connected to diluent gas introducing tube 111 at a point closer to plasma processing reaction chamber 101 than the points where doping gas introducing tubes 201a and 201b are connected, and the other end is connected to material gas feeding unit 204. A mass flow controller is provided as flow control device 115 in material gas feeding unit 204 and doping gas feeding units 202a and 202b, in order to feed the material gas and the doping gas at a predetermined flow rate, thereby allowing flow rate control.

SiH₄ gas is used as material gas 205, 0.5% H₂ dilution PH₃ gas 206a and 0.5% H₂ dilution B₂H₆ gas 206b are used as doping gas 206. Two kinds of doping gases 206a and 206b are the doping gases for n type and p type semiconductors, respectively, and either of them is selectively fed through valve 207.

Material gas feeding unit 204 and doping gas feeding units 202a and 202b are included in gas boxes 118, respectively, and gas box 118 is connected to an exhaust system for emitting the gas to the atmosphere through a harm eliminating device.

The configuration is such that pressure adjustment valve 117 and vacuum pump 116 are provided in series for plasma processing reaction chamber 101, so that the gas pressure in plasma processing reaction chamber 101 can be kept generally constant. In the present example, H₂ gas of 10 SLM, SiH₄ gas of 1 SLM, and 0.5% H₂ dilution PH₃ gas 206a or 0.5% H₂ dilution B₂H₆ gas 206b of 1 SLM are fed, and the gas pressure in plasma processing reaction chamber 101 is set to 150 Pa. The condition is by way of example and other gas flow rates and gas pressures are possible, however, normally hydrogen gas is set to 1 - 10 SLM, SiH₄ gas is set to 0.1 - 1 SLM, 0.5% hydrogen dilution PH₃ gas or 0.5% hydrogen dilution B₂H₆ gas is set to 0.1 - 1 SLM, and a gas pressure is set to 50 - 3000 Pa.

The configuration is such that electric power is supplied to cathode electrode 102 from plasma excitation power supply 104. As power supply 104, an alternating-current power supply with the frequency of 13.56 MHz and the output power of 1 kW is used. Although an alternating-current power supply with the frequency of about 1.00 MHz - 100 MHz and the output power of about 10 W - 100 kW is commonly used as power supply 104, it is not restricted as such but a direct-current power supply can also be used.

Between power supply 104 and plasma processing reaction chamber 101, matching box 105 matching the impedance between cathode electrode 102 / the anode electrode 103 and power supply 104 is disposed. Power supply 104 and matching box 105 are connected by power lead wire 106a, and matching box 105 and cathode electrode 102 are connected by power lead wire 106b. Anode electrode 103 is structured to be electrically grounded.

In the plasma processing apparatus configured as above, the silicon semiconductor thin film is deposited on the surface of the glass substrate serving as workpiece 107, by applying a high frequency power to cathode electrode 102 and generating a glow discharge region (plasma discharge region) between cathode electrode 102 and anode electrode 103.

This plasma CVD apparatus can be used for production of a semiconductor device using a silicon semiconductor thin film, such as a TFT or a thin film solar cell.

### (Example 3)

A plasma processing apparatus according to Example 3 is described based on a drawing, referring to a plasma CVD apparatus as an example.

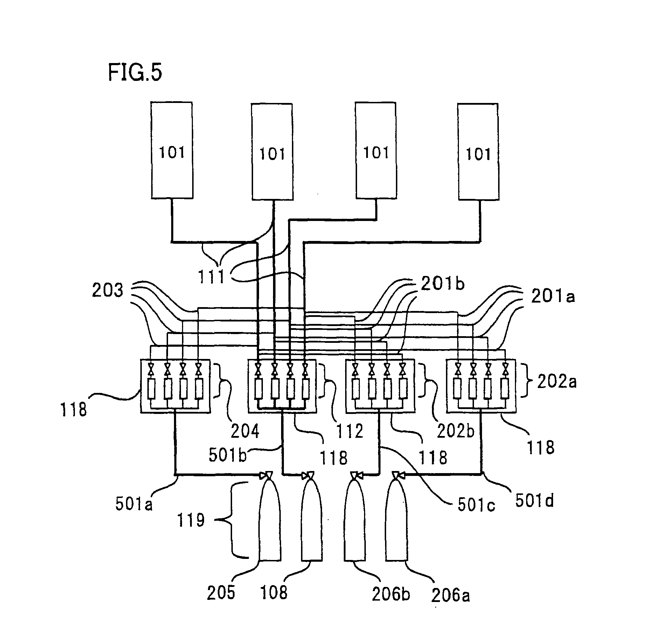

Fig. 5 is a diagram of a gas piping system of a plasma CVD apparatus according to the present example. Four plasma processing reaction chambers 101 are provided, and plasma processing reaction chambers 101 and diluent gas feeding units 112 put together in one place are connected by diluent gas introducing tubes 111, respectively.

Each plasma processing reaction chamber 101, and diluent gas introducing tube 111, material gas introducing tube 203, doping gas introducing tubes 201a and 201b, diluent gas feeding unit 112, material gas feeding unit 204, and doping gas feeding units 202a and 202b, corresponding to each plasma processing reaction chamber 101, are configured in the same way as in Example 2, and a similar silicon semiconductor film can be deposited.

In the present example, gas feeding units 112 for diluent gas 108, gas feeding units 204 for material gas 205, and gas feeding units 202a and 202b for doping gases 206 are put together in one place, that is, gas boxes 118, respectively. The present configuration is efficient because required gas boxes 118 can be reduced in number and the required gas detectors can be reduced in number.

Moreover, the present configuration is advantageous in that gases are mixed more efficiently while passing through diluent gas introducing tube 111 because the length of each diluent gas introducing tube 111 is inevitably long and its internal volume increases. Furthermore, the configuration has an effect of reducing the piping volume, because gas feed pipings 501a, 501b, 501c, and 501d from gas reservoirs 119 to gas feeding units 112, 202a, 202b and 204, corresponding to plasma processing reaction chambers 101, respectively, should only be provided for respective types of gases.

Although the embodiments and the examples of the present invention are described as above, combining the configurations of the above-described embodiments and examples as appropriate is originally intended. In addition, it is understood that the embodiments and examples disclosed herein are by way of illustration only and are not to be taken by way of limitation.

## Claims

1. A plasma processing apparatus comprising:
a plasma processing reaction chamber (101);
a diluent gas introducing tube (111) introducing a diluent gas, having one end connected to said plasma processing reaction chamber (101);
a diluent gas feeding unit (112) connected to an other end of said diluent gas introducing tube (111), for feeding the diluent gas; and
a reaction gas introducing tube (113) for introducing a reaction gas, having one end connected to said diluent gas introducing tube (111) at a location closer to said diluent gas feeding unit (112) with respect to a midpoint of said diluent gas introducing tube (111); and
a reaction gas feeding unit (114) connected to an other end of said reaction gas introducing tube (113), for feeding the reaction gas at a flow rate smaller than a flow rate of said diluent gas.

2. The plasma processing apparatus according to claim 1, wherein
said reaction gas introducing tube (113) is connected to said diluent gas introducing tube (111) in proximity of said diluent gas feeding unit (112).

3. The plasma processing apparatus according to claim 1, wherein
said reaction gas includes a material gas and a doping gas,
said reaction gas introducing tube (113) includes a material gas introducing tube (203) introducing said material gas and a doping gas introducing tube (201) introducing said doping gas, and
said material gas introducing tube (203) is connected to said diluent gas introducing tube (111) at a location closer to said plasma processing reaction chamber (101) with respect to said doping gas introducing tube (201).

4. The plasma processing apparatus according to claim 1, wherein
an inner diameter of said diluent gas introducing tube (111) is larger than an inner diameter of said reaction gas introducing tube (113).

5. The plasma processing apparatus according to claim 1, wherein
a plurality of sets of said plasma processing reaction chamber (101), said diluent gas introducing tube (111), said diluent gas feeding unit (112), said reaction gas introducing tube (113) and said reaction gas feeding unit (114) are provided, and
said diluent gas feeding units (112) are included in one vessel and said reaction gas feeding units (114) are included in one vessel.

6. The plasma processing apparatus according to claim 1, wherein
said diluent gas is an inert gas or a hydrogen gas.

7. The plasma processing apparatus according to claim 1, wherein
said diluent gas feeding unit (112) includes a first gas box (118), and a first flow control device (115) and a first valve (207) provided in the first gas box, and
said reaction gas feeding unit (114) includes a second gas box (118), and a second flow control device (115) and a second valve (207) provided in the second gas box.

8. The plasma processing apparatus according to claim 1, further comprising:
a gas inlet (110) to which one end of said diluent gas introducing tube (111) is connected;
cathode electrode (102) and anode electrode (103) arranged opposed to each other in said plasma processing reaction chamber (101);
a vacuum pump (116) connected to said plasma processing reaction chamber (101); and
a pressure adjustment valve (117) connected to plasma processing reaction chamber (101) via said vacuum pump (116), wherein
said vacuum pump (116) is connected to said plasma processing reaction chamber (101) on a side opposite to said gas inlet (110) with respect to said cathode electrode (102) and anode electrode (103).

9. A semiconductor device manufactured with the plasma processing apparatus according to claim 1.
